(19) 

Europäisches
Patentamt

European
Patent Office

Office européen
des brevets

(11) **EP 4 674 561 A1**

(12) **EUROPEAN PATENT APPLICATION**
published in accordance with Art. 153(4) EPC

(43) Date of publication:
**07.01.2026  Bulletin 2026/02**

(21) Application number: **24796931.4**

(22) Date of filing: **19.04.2024**

(51) International Patent Classification (IPC):
**B23K 35/26** (2006.01)    **C22C 13/00** (2006.01)
**H05K 3/34** (2006.01)

(52) Cooperative Patent Classification (CPC):
**B23K 35/26; C22C 13/00; H05K 3/34**

(86) International application number:
**PCT/JP2024/015538**

(87) International publication number:
**WO 2024/225184 (31.10.2024 Gazette 2024/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **28.04.2023   JP 2023074902**

(71) Applicant: Senju Metal Industry Co., Ltd.
**Tokyo 120-8555 (JP)**

(72) Inventors:
• **SUGISAWA, Kota**
  **Tokyo 120-8555 (JP)**
• **IIJIMA, Yuki**
  **Tokyo 120-8555 (JP)**
• **YOSHIKAWA, Shunsaku**
  **Tokyo 120-8555 (JP)**

(74) Representative: **Zimmermann & Partner
Patentanwälte mbB
P.O. Box 330 920
80069 München (DE)**

(54) **SOLDER ALLOY, SOLDER BALL, SOLDER PREFORM, SOLDER JOINT, AND CIRCUIT**

(57)  Provided are a solder alloy, a solder ball, a solder preform, a solder joint, and a circuit which have excellent wettability and shear strength, as well as an appropriate fracture mode, suppressed growth of an intermetallic compound at a joint interface even after reflowing is performed a plurality of times, excellent drop impact resistance, and an appropriate bump shape. The solder alloy has an alloy composition consisting of, by mass%, Ag: 0.10 to 3.00%, Cu: 0.80 to 6.00%, Ni: 0.08 to 0.60%, Ge: 0.0010 to 0.0150%, with the balance being Sn. Preferably, the alloy composition further contains at least one of Bi, Sb, In, Zn, Ga, Mn, Cr, Co, Si, Ti, and rare earth elements: 0.1% or less in total.

## FIG. 1

Intermetallic compound

EP 4 674 561 A1

**Description**

Technical Field

The present invention relates to a solder alloy, a solder ball, a solder preform, a solder joint, and a circuit.

Background Art

In recent years, electronic devices have been required to be highly integrated, light, thin, short, and small. Electronic components mounted on electronic devices are also required to be reduced in size and thickness. As a semiconductor package satisfying these requirements, BGA (a ball grid array), which is an area-array surface-mount package, is mainly used. The BGA has external electrode terminals in which solder balls are arranged in a lattice pattern at equal intervals on a mounting substrate of a package. Solder balls are placed on the electrodes, and then heated together with the mounting substrate and melted in a reflow furnace to form solder bumps.

To meet further demands for highly integrated, lighter, thinner, shorter, and smaller electronic devices, electronic components may be connected to both surfaces of a substrate. To connect the electronic components to both surfaces of the substrate, first reflow soldering is performed on one surface, and then second reflow soldering is performed on the other surface. In addition, in the power semiconductor substrate, third reflow soldering is performed to further connect a heat sink. As described above, when reflow soldering is performed a plurality of times, the solder alloy used for the first or second soldering is repeatedly melted and solidified.

By the way, in the conventional BGA, an Sn-Ag-Cu-based solder alloy represented by Sn-3.0Ag-0.5Cu has been used. However, when such reflow soldering is performed a plurality of times, voids are generated at a joint interface between the solder alloy constituting the solder joint and the electrode. As voids grow, shear strength and drop impact resistance properties are deteriorated. Further, as the melting and solidification of the solder alloy are repeated, the oxidation of the solder alloy progresses, and the wettability may deteriorate.

Hence, patent Document 1 discloses an Sn alloy containing 1 to 9% of Cu and also containing various optional elements from the viewpoint of suppressing deterioration of reliability of a solder joint due to reflow soldering performed a plurality of times. Specifically, Sn-Cu-Ni-based solder alloys and Sn-Cu-Ni-Ge-based solder alloys are disclosed. These solder alloys further contain P and the like. It is also disclosed that Ag may be contained as an optional element. Shear strength after reflow soldering performed a plurality of times, die tilt, and void growth are evaluated in the same document.

Patent Document 2 discloses an Sn-Ag-Cu-Ni solder alloy in order to improve the drop impact resistance by lowering the hardness of the solder alloy. In the invention described the same document, it is described that P and Ge are contained as elements that suppress discoloration of the solder alloy.

Patent Document 3 discloses an Sn-Ag-Cu-Ni-Ge solder alloy as an inexpensive quinary solder alloy having good bondability. In the invention described the same document, the occurrence rate of voids and the breaking elongation are evaluated. Additionally, the same document also is described that the breaking elongation is improved by reducing the generation of voids and also reducing the film thickness of Cu3Sn. The same document also discloses that oxidation is suppressed as a reason for adding Ge.

Patent Document 4 discloses a solder alloy in which an Sn-Ag-Cu solder alloy contains a predetermined amount of at least one of La, Ce, Pr, Nd, Sm, Yb, Y, Gd, and Dy in order to improve joint strength while reducing the Ag content. The same document also discloses that Ni or Fe may further be contained in order to refine the crystal of the solidified structure of the solder alloy and improve the mechanical strength. Further, the same document discloses that P, Ga, and Ge may be contained as elements that are very easily oxidized in order to suppress the occurrence of dross due to the oxidation of La, Ce, Pr, Nd, Sm, Yb, Y, Gd, Dy, Ni and Fe.

Citation List

Patent Document

Patent Document 1: International Publication No. WO 2020/135932
Patent Document 2: International Publication No. WO 2007/102588
Patent Document 3: Japanese Unexamined Patent Application Publication No. 2008-93701 A
Patent Document 4: Japanese Unexamined Patent Application Publication No. 2013-049073 A

Summary of Invention

Technical Problem

In Patent Document 1, various evaluations are made on the alloy composition containing Sn and Cu. However, evaluation is performed with an alloy composition having different constituent elements according to each evaluation item. For example, in the evaluation on die tilt, a solder alloy having constituent elements exhibiting a melting point such that it does not melt in second reflow or maintains a high viscosity even when melted is used. The void growth and the shear strength after reflow soldering performed a plurality of times are similarly evaluated with solder alloys consisting of different constituent elements.

As described above, in the invention described in Patent Document 1, constituent elements other than Sn and Cu are different according to each evaluation item, although various evaluations have been made. Therefore, an alloy composition satisfying all the evaluation items mentioned in Patent Document 1 is not disclosed. In addition, as described above, Patent Document 1 discloses that Ag may be contained. However, Ag-containing alloy compositions have not been evaluated. Therefore, in the invention described in Patent Document 1, the effect of adding Ag is not verified.

In the inventions described in Patent Document 2 and Patent Document 3, the Ni content is reduced in both the inventions to improve the properties of the joint interface, thereby improving the drop impact resistance. In the invention described in Patent Document 4, the joint interface is miniaturized by expensive rare metals.

As described above, in Patent Documents 1 to 4, a joint interface of a solder joint is studied. Improving the properties of the joint interface of the solder joint is an important objective in solder alloys. However, even if the load on the solder joint becomes large, a fracture mode should not be such that the joint interface breaks. In the solder joint, since physical and electrical loads are mainly applied to the joint interface, it is desired that the solder joint is firmly joined at the joint interface.

As described above, evaluation of a solder joint in an extreme state is an important index for confirming that a good solder joint is formed. However, since the fracture mode is not examined in Patent Documents 1 to 4, it is unclear whether a solder joint having a good joint interface is formed.

In addition, the evaluation items studied in Patent Documents 1 to 4 are all performed after the solder joint is formed. As a property of the solder alloy before the solder joint is formed, excellent wettability of the molten solder is also important. In Patent Documents 1 to 4, wettability is mentioned, but no evaluation with a specific alloy composition is performed on wettability.

Furthermore, in bonding to a substrate such as a BGA, the shape of the solder bump needs to be appropriate as a form before the solder joint is formed. This is because when the solder bump is deformed, there is a high likelihood that some problem will occur during soldering. However, the shape of the solder bump for forming the solder joint is not studied at all in Patent Documents 1 to 4.

The solder bump is formed by melting a solder ball on an electrode, then solidifying the solder ball, and joining the solder ball to the electrode. Therefore, it is considered preferable that the surface has a substantially elliptical shape. On the other hand, a hole may be formed in the solder bump to cause unevenness on the surface, a needle-shaped intermetallic compound may protrude on the surface of the solder bump, or the shape may be an irregular shape greatly deviated from a substantially elliptical shape. Such solder bumps are likely to cause bonding defects or short circuit between the electronic component and the substrate. In recent years, due to downsizing and thinning of electronic components, bonding defects due to irregularly-shaped bumps have been increasing year by year, and thus prompt improvement is desired.

Therefore, an object of the present invention is to provide a solder alloy, a solder ball, a solder preform, a solder joint, and a circuit which have excellent wettability and shear strength, as well as an appropriate fracture mode, suppressed growth of an intermetallic compound at a joint interface even after reflowing is performed a plurality of times, excellent drop impact resistance, and an appropriate bump shape.

Solution to Problem

The present inventors have studied various alloy compositions of the solder alloy disclosed in Patent Documents 2 to 4 in order to solve the problem of the present invention. Specifically, evaluation was performed with an Sn-1.0Ag-1.0Cu-0.1Ni solder alloy not containing Ge, which is the alloy composition of Example 10 in Patent Document 2. Consequently, it was found that an abnormality occurs in the solder bump.

Therefore, the present inventors have evaluated an Sn-1.0Ag-1.0Cu-0.1Ni-0.02Ge solder alloy obtained by adding Ge to the Sn-1.0Ag-1.0Cu-0.1Ni solder alloy. As a result, abnormality of the solder bump was observed, and it was found that wettability was poor.

Next, a study was conducted focusing on the Ni content. In paragraphs 0072 and 0139 of Patent Document 2, it is explained that when the Ni content is more than 0.07%, the solder alloy before reflow is hardened to such an extent that there is no problem in practical use, and thus the drop impact resistance is poor. Meanwhile, in paragraph 0063 of the same document, it is described that Ni alleviates strain between a $(Cu, Ni)_6Sn_5$ intermetallic compound in which a part of Cu is substituted with Ni and an adjacent $Cu_3Sn$ intermetallic compound. In view of these facts, it is presumed that the Sn-Ag-Cu-Ni-Ge solder alloy disclosed in the same document discloses only an alloy composition of 0.05% in which the Ni content is close to 0.07%.

In addition, FIGS. 3 and 4 of Patent Document 3 disclose that generation of voids cannot be suppressed when the Ni content is more than 0.05%. Further, FIG. 5 of the same document discloses that the alloy composition containing 0.03% of Ni has the same breaking elongation as that of the alloy composition containing 0.07% of Ni, and does not need to contain more than 0.05% of Ni.

Therefore, in view of these descriptions, the present inventors evaluated the alloy composition in which the Ni content was reduced to 0.05% in the Sn-Ag-Cu-Ni-Ge solder alloy. As the result, similarly to the alloy composition in which the Ni content is 0.07%, it has been found that the shear strength is poor and abnormality occurs in the solder bump.

Additionally, since Patent Document 4 is described that the Ag content is reduced, an Sn-Ag-Cu-Ni-Ge solder alloy in which the Ag content is reduced to 0.05% was evaluated. As a result, it was found that the wettability and the shear strength were poor although the abnormality of the solder bump was reduced.

In view of these findings, in the Sn-Ag-Cu-Ni-Ge solder alloy, it is considered difficult to solve the problem of the present invention even in view of the conventional alloy composition and the tendency of the effects. Therefore, in order to obtain an Sn-Ag-Cu-Ni-Ge solder alloy that simultaneously satisfies all the effects mentioned in the problems of the present invention, the present inventors have taken a different approach from that of a conventional one and have studied an alloy composition that increases the Ni content to 0.08% or more. Further, investigations were made on detailed adjustment of contents of Ag, Cu, and Ge at the same time.

Note that, as described in paragraphs 0072 and 0139 of Patent Document 2, in view of the fact that characteristics are exhibited to such an extent that there is no problem in practical use even if the characteristics are slightly deteriorated, it is considered that it is not necessary to achieve all the objects listed in the object of the present invention at a level higher than necessary. For this reason, the above examination has been performed so that the effects without a problem in practical use are achieved.

As a result, it has been found that when the Ni content is increased and each constituent element is within a predetermined range, it is possible to achieve excellent wettability and shear strength, as well as an appropriate fracture mode, suppressed growth of an intermetallic compound at a joint interface even after reflowing is performed a plurality of times, excellent drop impact resistance, and appropriate bump shape, whereby the present invention has been completed.

The present invention obtained from these findings is as follows.

(0) A solder alloy having, by mass%, Ag: 0.10 to 3.00%, Cu: 0.80 to 6.00%, Ni: 0.08 to 0.60%, Ge: 0.0010 to 0.0150%, with the balance being Sn, and unavoidable impurity.

(1) A solder alloy containing, by mass%, an alloy composition consisting of Ag: 0.10 to 3.00%, Cu: 0.80 to 6.00%, Ni: 0.08 to 0.60%, Ge: 0.0010 to 0.0150%, with the balance being Sn.

(2) The solder alloy according to any one of (0) or (1) above, wherein the alloy composition further contains 0.1% or less in total of at least one of Bi, Sb, In, Zn, Ga, Mn, Cr, Co, Si, Ti, and rare earth elements.

(3) The solder alloy according to any one of (0) to (2) above, wherein the alloy composition satisfies the following Relations (1) and (2):

$$0.00043 \leqq Cu \times Ni \times Ge \leqq 0.00149 \qquad (1)$$

$$0.09 \leqq Ag \times Cu \times Ni \leqq 0.11 \qquad (2)$$

where Ag, Cu, Ni, and Ge in Relations (1) and (2) above represent the contents (mass%) thereof in the alloy composition.

(4) A solder ball consisting of the solder alloy according to any one of (0) to (3) above.

(5) A solder preform consisting of the solder alloy according to any one of (0) to (3) above.

(6) A solder joint including the solder alloy according to any one of (0) to (3) above.

(7) A circuit including the solder according to (6) above.

Brief Description of Drawings

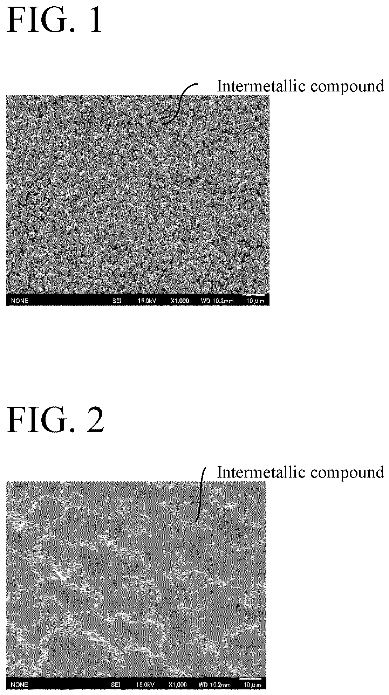

FIG. 1 is a surface SEM photograph of an intermetallic compound formed at a joint interface in a solder joint produced using a solder alloy of Example 3.

FIG. 2 is a surface SEM photograph of an intermetallic compound formed at a joint interface in a solder joint produced using a solder alloy of Comparative Example 4.

Description of Embodiments

The present invention will be described in greater detail below. In this description, "%" relating to the solder alloy composition refers to "mass%" unless otherwise specified.

1. Solder Alloy

(1) Ag:0.10 to 3.00%

Ag contributes to improvement of wettability. Further, the shear strength can be improved by precipitation of fine $Ag_3Sn$. When the Ag content is less than 0.10%, wettability is reduced, and shear strength is reduced due to bonding defects between the solder alloy and the electrode. In terms of the lower limit, the Ag content is 0.10% or more, preferably 0.50% or more, and more preferably 0.90% or more.

On the other hand, when the Ag content is more than 3.00%, the shear strength decreases due to precipitation of coarse $Ag_3Sn$, and the drop impact resistance decreases after a plurality of times of reflow. In terms of the upper limit, the Ag content is 3.00% or less, preferably 2.50% or less, more preferably 2.00% or less, further preferably 1.50% or less, particularly preferably 1.10% or less, and most preferably 1.00% or less.

(2) Cu:0.80 to 6.00%

Cu contributes to the improvement of the shear strength by controlling the growth of the intermetallic compound precipitated at the joint interface. Further, although a thin and brittle compound is formed on the surface of the molten solder together with Ge to be described later, the compound is easily broken by convection of the molten solder, and the surface of the molten solder is cleaned, so that the surface tension of the molten solder is improved to suppress the deformation of the solder bump. Further, Cu improves drop impact resistance and wettability, and can also optimize a fracture mode.

When the Cu content is less than 0.80%, the effect of suppressing the growth of the intermetallic compound at the joint interface is not exhibited, and the shear strength decreases. Further, a thin compound of Ge and Cu is not formed on the surface of the molten solder, and the solder bump is deformed. In terms of the lower limit, the Cu content is 0.80% or more, preferably 0.95% or more.

On the other hand, when the Cu content is more than 6.00%, the liquidus-line temperature excessively increases, so that wettability is deteriorated. Further, a coarse intermetallic compound is precipitated at the joint interface, the drop impact resistance and the shear strength are poor, and the fracture mode becomes inappropriate. Furthermore, since a large amount of a thick compound of Ge and Cu is precipitated on the surface of the molten solder, the surface tension of the molten solder is reduced, and the solder bump is deformed. In terms of the upper limit, the Cu content is 6.00% or less, preferably 5.00% or less, more preferably 4.00% or less, further preferably 3.00% or less, still further preferably 2.00% or less, particularly preferably 1.20% or less, most preferably 1.05% or less, and may be 1.00% or less.

(3) Ni:0.08 to 0.60%

Similarly to Cu, Ni contributes to improvement of shear strength and suppression of deformation of solder bumps. Further, Ni improves drop impact resistance and wettability, and can also optimize a fracture mode. When the Ni content is less than 0.08%, the effect of suppressing the growth of the intermetallic compound at the joint interface is not exhibited, and the shear strength decreases. Further, a thin compound of Ge and Ni is not formed on the surface of the molten solder, and the solder bump is deformed. In terms of the lower limit, the Ni content is 0.08% or more, preferably 0.09% or more.

On the other hand, when the Ni content is more than 0.60%, wettability is deteriorated similarly to Cu, and further, a coarse intermetallic compound is precipitated at the joint interface, the drop impact resistance and the shear strength are poor, and the fracture mode becomes inappropriate. Furthermore, since a large amount of a compound of Ge and Ni is precipitated on the surface of the molten solder, the solder bump is deformed. In terms of the upper limit, the Ni content is 0.60% or less, preferably 0.50% or less, more preferably 0.40% or less, further preferably 0.30% or less, still further preferably 0.20% or less, particularly preferably 0.12% or less, most preferably 0.11% or less, and may be 0.10% or less.

(4) Ge:0.0010 to 0.0150%

Ge forms a compound with Cu and Ni, and these compounds move to the surface of the molten solder. However, convection of the molten solder breaks these compounds, and cleaning of the surface of the molten solder suppresses deformation of the solder bump. When the Ge content is less than 0.0010%, the compound of Cu and Ni is not sufficiently precipitated on the surface of the molten solder, and the solder bump is deformed. In terms of the lower limit, the Ge content is 0.0010% or more, preferably 0.0020% or more, more preferably 0.0050% or more, and further preferably 0.0060% or more.

On the other hand, when the Ge content is more than 0.0150%, the compound of Cu and Ni becomes thick on the surface of the molten solder, and these compounds remain on the surface of the solder alloy during solidification, so that the solder bump is deformed. And wettability also decreases. In terms of the upper limit, the Ge content is 0.0150% or less, preferably 0.0120% or less, more preferably 0.0100% or less, and particularly preferably 0.0080% or less.

(5) A total amount of at least one of Bi, Sb, In, Zn, Ga, Mn, Cr, Co, Si, Ti, and rare earth elements is 0.1% or less.

The solder alloy according to the present invention may contain, as an optional element, at least one of Bi, Sb, In, Zn, Ga, Mn, Cr, Co, Si, Ti, and rare earth elements in a total amount of 0.1% or less as long as the effect of the present invention is not affected. In the present invention, the rare earth element represents 17 kinds of elements obtained by combining Sc and Y belonging to Group 3 in the periodic table and 15 elements of the lanthanum group corresponding to the atomic numbers 57 to 71. In terms of the upper limit, the content of the optional element is not particularly limited, but is preferably 0.1% or less, and more preferably 0.01% or less. A lower limit is also not particularly limited, but is preferably 0.001% or more.

(6) Relations (1) and (2)

$$0.00043 \leqq Cu \times Ni \times Ge \leqq 0.00149 \qquad (1)$$

$$0.09 \leqq Ag \times Cu \times Ni \leqq 0.11 \qquad (2)$$

where Ag, Cu, Ni, and Ge represent the contents (mass%) of the alloy composition in Relations (1) and (2).

The solder alloy according to the present invention preferably satisfies Relations (1) and (2). When these relations are satisfied, the fracture mode is further optimized, the shear strength is further improved, the drop impact resistance is further improved even after reflowing is performed a plurality of times, the intermetallic compound precipitated at the joint interface becomes fine, and the deformation of the solder bump is also suppressed. Relation (1) is a relation composed of Cu, Ni, and Ge, which are elements that suppress the deformation of the solder bump. The Ge content is smaller than the Cu or Ni content, but Ge forms a compound with Cu or Ni and greatly affects the behavior of the alloy structure in the solidification process, and thus a small amount contributes greatly to the characteristics of the solder alloy. Therefore, the content of each constituent element can be expressed as an relation directly without multiplying Ge by a coefficient.

Relation (2) is a relation composed of Ag, Cu, and Ni, which contributes to improvement of wettability and shear strength. The solder joint should not break at the joint interface, but the strength of the solder alloy itself should not be too weak. In this regard, Ag is a precipitation-strengthened element, and by satisfying Relation (2), the strength of the solder alloy itself can be improved to some extent to the extent that the fracture mode is not inappropriate. Further, Cu and Ni contribute to the formation of fine intermetallic compounds at the joint interface and the liquidus-line temperature, and thus affect the overall characteristics of the solder joint together with Ag.

These relations are obtained by mutual dependence of constituent elements. This is because the alloy is an integral body in which all constituent elements are combined, and each constituent element affects each other. As described above, the solder alloy according to the present invention that satisfies Relations (1) and (2) after being adjusted to the optimum content of each constituent element is set within a range sufficiently considering that each constituent element depends on each other. Therefore, the alloy composition in which each constituent element is within the above range and satisfies Relations (1) and (2) exhibits excellent drop impact resistance even after soldering a plurality of times, and coarsening of the intermetallic compound precipitated at the joint interface is suppressed. In addition, at the same time, excellent wettability and shear strength are obtained, the fracture mode is appropriate, and the solder bump can be suppressed from being deformed at a high level.

In terms of the lower limit, Relation (1) is preferably 0.00043 or more, more preferably 0.00060 or more, further preferably 0.00064 or more, particularly preferably 0.00072 or more, and most preferably 0.00076 or more. In terms of the upper limit, Relation (1) is preferably 0.00149 or less, more preferably 0.00120 or less, further preferably 0.00100 or less, still further preferably 0.00096 or less, particularly preferably 0.00088 or less, most preferably 0.00086 or less, and may be0.00084 or less, or 0.00080 or less.

In terms of the lower limit, Relation (2) is preferably 0.09 or more, and more preferably 0.095 or more. In terms of the upper limit, Relation (2) is preferably 0.11 or less, more preferably 0.105 or less, and still more preferably 0.10 or less.

(7) Balance: Sn

The balance of the solder alloy according to the present invention is Sn. In addition to the above-described elements, unavoidable impurity may be contained. The solder alloy according to the present invention may contain Sn and unavoidable impurities as the balance. Even when unavoidable impurity is contained, it does not affect the above-described effects. Note that P is preferably not contained in the solder alloy according to the present invention because it forms a compound with Cu, Ni, and Ge on the surface of the molten solder, resulting in poor wettability and deformation of the bump. Fe is preferably not contained in the solder alloy according to the present invention because it forms an oxide film that is difficult to remove with a flux, resulting in poor wettability and deformation of the bump. Ce is preferably not contained in the solder alloy according to the present invention because the melting point of the solder alloy increases to form an oxide film and a compound, and a coarse intermetallic compound is also formed at the joint interface, so that the effect of the present invention cannot be exhibited.

2. Solder Ball

The solder alloy according to the present invention can be used as a solder ball. The solder ball according to the present invention is used for forming bumps on an electrode or a substrate of a semiconductor package such as BGA (a ball grid array). The diameter of the solder ball according to the present invention is preferably within a range of 1 to 1000 $\mu$m. The solder ball can be manufactured by a general manufacturing method for solder balls.

3. Solder Preform

The shape of the solder preform according to the present invention is not particularly limited, and the solder preform can be used in a form such as a plate shape, a ring shape, a cylindrical shape, a ribbon shape, a square shape, a disk shape, a washer shape, a chip shape, or a wire shape. The solder preform may contain therein high melting point metal grains (for example, Ni grains, Cu grains, and alloy powder containing Ni or Cu as a main component) having a melting point higher than that of the solder alloy and easily wetted with molten solder.

4. Solder Joint

A solder joint according to the present invention is preferably used to join at least two to-be-joined members. The to-be-joined members are not particularly limited as long as they are electrically connected by using the solder alloy according to the present invention, for example, element, substrates, electronic components, printed circuit boards, insulated substrates, heatsinks, lead frames, semiconductor which has electrode terminals etc., power module, and inverter products, etc.
A joining method using the solder alloy according to the present invention is performed in the usual manner by using, for example, a reflow method. A melting temperature of the solder alloy when flow soldering is performed may be a temperature approximately 20°C higher than the liquidus-line temperature. In addition, in the case of joining using the solder alloy according to the present invention, the alloy structure can be made finer taking a cooling rate for solidification into consideration. For example, a solder joint is cooled at a cooling rate of 2 to 3°C/s or more. Other joining conditions can be adjusted as appropriate according to the alloy composition of the solder alloy.

5. Circuit

Since the circuit according to the present invention is an electric circuit and includes the solder joint described above, the circuit is preferably an in-vehicle electronic circuit that requires excellent reliability, particularly a hybrid semiconductor circuit. In addition, the present invention including a solder alloy can also be used for a power module.

6. Other

As the solder alloy according to the present invention, by using a low $\alpha$ dose material as a raw material, a low $\alpha$ dose alloy can be produced. Such a low $\alpha$ dose alloy can prevent a soft error when used for forming solder bumps around a memory.

Examples

The present invention will be described based on the following examples, however, the present invention is not limited to the following examples.

In order to verify the effect of the present invention, the solder alloy described in Table 1 was used to evaluate (1) Wettability, (2) Shear Strength, (3) Fracture Mode, (4) Drop Impact, (5) IMC Crystal Grain Size, and (6) Deformed Bump.

(1) Wettability

Solder balls having a diameter of 0.3 mm were prepared from the solder alloys shown in the following Tables 1 and 2. A flux (WF-6317 manufactured by SMIC) was applied to a substrate (S/F: Cu-OSP), and then the obtained solder ball was mounted. Subsequently, reflow soldering (heating temperature: 220°C or higher, retention time: 40 seconds, peak temperature: 245°C) was performed using a reflow device (manufactured by SMIC: SNR-615). After the reflow, the wetting spread length, which is the maximum length among the distances between two parallel lines sandwiching the wetting spread planar projection image, was measured using a digital microscope (VHX-7000 manufactured by KEYENCE CORPORATION). The used substrate material was a glass epoxy substrate (FR-4) having a thickness of 1.2 mm. The sample was judged as "Excellent" when the wet-spreading length was 900 $\mu$m or more, the sample was judged as "Good" when the wet-spreading length was 800 $\mu$m or more and less than 900 $\mu$m, and the sample was judged as "Poor" when the wet-spreading length was less than 800 $\mu$m. In this example, "Good" and "Excellent" were evaluation results having no practical problem.

(2) Shear Strength

Solder balls having a diameter of 0.3 mm were prepared from the solder alloys shown in the following Tables 1 and 2. The solder balls were placed on a substrate having a thickness of 1.2 mm and an electrode size of 0.5 mm (Cu-OSP), and soldering was performed. The number of solders was 10. As soldering conditions, a flux (WF-6400, manufactured by SMIC) was applied onto an electrode, and soldering was performed using a reflow device (SNR-615, manufactured by SMIC) with a reflow profile of a heating temperature of 220°C or higher, a retention time of 40 seconds, a peak temperature of 245°C, and a cooling rate of 2°C/s. The prepared substrate was subjected to a shear strength test under the condition of a shear rate of 1000 mm/s using a shear strength measuring device (SERIES 4000HS manufactured by Nordson DAGE). When the average joint strength of 10 pieces was 5.5 N or more, it was judged as "Excellent", when the average joint strength was 4.6 N or more and less than 5.5 N, it was judged as "Good", and when the average joint strength was less than 4.6 N, it was judged as "Poor". In this example, "Good" and "Excellent" were evaluation results having no practical problem.

(3) Fracture Mode

Using a digital microscope (VHX-7000 manufactured by KEYENCE CORPORATION), it was observed that the sample after the shear strength test was broken at the bulk or the joint interface. A sample was judged as "Excellent" when all of 10 solder alloys (bulk) were fractured, a sample was judged as "Good" when 9 of 10 solder alloys (bulk) were fractured, and a sample was judged as "Poor" when 8 or less of 10 solder alloys (bulk) were fractured. In this example, "Good" and "Excellent" were evaluation results having no practical problem.

(4) Drop Impact

Solder balls having a diameter of 0.3 mm were prepared from the solder alloys shown in the following Tables 1 and 2. The solder balls were soldered to a module substrate for CSP having a size of 12 × 12 mm using a flux WF-6317 manufactured by SMIC and a CSP using a solder alloy of each composition for an electrode was prepared. A glass epoxy substrate (FR-4) having a size of 30 × 120 mm and a thickness of 0.8 mm was printed with a solder paste according to an electrode pattern, the prepared CSP was mounted thereon, and soldering was performed using a reflow device (SNR-615 manufactured by SMIC) to prepare an evaluation substrate with a reflow profile having a heating temperature of 220°C or higher, a retention time of 40 seconds, and a peak temperature of 245°C.

The prepared evaluation substrate was subjected to a drop impact test under the following conditions. In the test method, both ends of the substrate were fixed using a dedicated jig at a position where the evaluation substrate was floated 10 mm from the base. In accordance with the JEDEC standard, an impact with an acceleration of 1500G was repeatedly applied, and a time point at which the resistance value increased by 1.5 times from the initial resistance value was regarded as a break, and the number of drops was recorded. A case where the number of breaking times was 210 or more was judged as "Excellent," a case where the number of breaking times was 150 or more and 209 or less was judged as "Good," and a case where the number of breaking times was 149 or less was judged as "Poor". In this example, "Good" and "Excellent" were evaluation results having no practical problem.

(5) IMC Crystal Grain Size

The substrate above after the fracture mode observation was subjected to removal of the solder bulk remaining on the surface using a metal release agent to expose crystal grains of the intermetallic compound. Thereafter, the exposed intermetallic compound was photographed at a magnification of 3000 using a scanning electron microscope (JSM-7000F manufactured by JEOL). Thereafter, using image analysis software (manufactured by EMSIS GmbH: Scandium) attached to a scanning electron microscope, the total area of each crystal grain was determined from the photographed image, and divided by the number of crystal grains to calculate the average area (S) of crystal grains. From the average area (S), the square root of $(4S/\pi)$ was determined and taken as the crystal grain size. When the grain size of IMC was 3 $\mu$m or less, it was judged as "Excellent," when it was more than 3 $\mu$m and 6 $\mu$m or less, it was judged as "Good," and when it was more than 6 $\mu$m, it was judged as "Poor". In this example, "Good" and "Excellent" were evaluation results having no practical problem.

(6) Deformed Bump

Solder balls having a diameter of 0.3 mm were prepared from the solder alloys shown in the following Tables 1 and 2. The solder balls were placed on a substrate having a thickness of 1.2 mm and an electrode size of 0.5 mm (Cu-OSP), and soldering was performed. The number of solders was 30. As soldering conditions, a flux (WF-6400, manufactured by SMIC) was applied onto an electrode, and soldering was performed using a reflow device (SNR-615, manufactured by SMIC) with a reflow profile of a heating temperature of 220°C or higher, a retention time of 40 seconds, a peak temperature of 245°C, and a cooling rate of 2°C/s. After soldering, observation was performed using a scanning electron microscope (JSM-7000F manufactured by JEOL). Among the 30 bumps, 0 deformed bump was judged as "Excellent," 1 or more and 2 or less deformed bumps were judged as "Good," and 3 or more deformed bumps were judged as "Poor". In this example, "Good" and "Excellent" were evaluation results having no practical problem.

The evaluation results are shown in Tables 1 and 2.

[Table 1]

| | Alloy Composition (mass%) | | | | | | Relation (1) | Relation (2) | Wettability | Fracture Mode | Shear Strength (Mpa) | Drop Impact | IMC Crystal Grain Size | Deformed Bump |
|---|---|---|---|---|---|---|---|---|---|---|---|---|---|---|
| | Sn | Ag | Cu | Ni | Ge | Others | | | | | | | | |
| Example1 | Bal. | 0.10 | 1.00 | 0.10 | 0.0080 | | 0.00080 | 0.01 | Good | Excellent | Good | Excellent | Excellent | Excellent |
| Example2 | Bal. | 0.90 | 1.00 | 0.10 | 0.0080 | | 0.00080 | 0.09 | Excellent | Excellent | Excellent | Excellent | Excellent | Excellent |
| Example3 | Bal. | 1.00 | 1.00 | 0.10 | 0.0080 | | 0.00080 | 0.10 | Excellent | Excellent | Excellent | Excellent | Excellent | Excellent |
| Example4 | Bal. | 1.10 | 1.00 | 0.10 | 0.0080 | | 0.00080 | 0.11 | Excellent | Excellent | Excellent | Excellent | Excellent | Excellent |
| Example5 | Bal. | 2.00 | 1.00 | 0.10 | 0.0080 | | 0.00080 | 0.20 | Excellent | Excellent | Excellent | Good | Good | Excellent |
| Example6 | Bal. | 3.00 | 1.00 | 0.10 | 0.0080 | | 0.00080 | 0.30 | Excellent | Excellent | Good | Good | Good | Excellent |
| Example7 | Bal. | 1.00 | 0.80 | 0.10 | 0.0080 | | 0.00064 | 0.08 | Excellent | Excellent | Good | Excellent | Excellent | Good |
| Example8 | Bal. | 1.00 | 0.95 | 0.10 | 0.0080 | | 0.00076 | 0.10 | Excellent | Excellent | Excellent | Excellent | Excellent | Excellent |
| Example9 | Bal. | 1.00 | 1.05 | 0.10 | 0.0080 | | 0.00084 | 0.11 | Excellent | Excellent | Excellent | Excellent | Excellent | Excellent |
| Example10 | Bal. | 1.00 | 1.20 | 0.10 | 0.0080 | | 0.00096 | 0.12 | Good | Good | Excellent | Good | Good | Good |
| Example11 | Bal. | 1.00 | 2.00 | 0.10 | 0.0080 | | 0.00160 | 0.20 | Good | Good | Good | Good | Good | Good |
| Example12 | Bal. | 1.00 | 3.00 | 0.10 | 0.0080 | | 0.00240 | 0.30 | Good | Good | Good | Good | Good | Good |
| Example13 | Bal. | 1.00 | 4.00 | 0.10 | 0.0080 | | 0.00320 | 0.40 | Good | Good | Good | Good | Good | Good |
| Example14 | Bal. | 1.00 | 5.00 | 0.10 | 0.0080 | | 0.00400 | 0.50 | Good | Good | Good | Good | Good | Good |
| Example15 | Bal. | 1.00 | 6.00 | 0.10 | 0.0080 | | 0.00480 | 0.60 | Good | Good | Good | Good | Good | Good |
| Example16 | Bal. | 1.00 | 1.00 | 0.08 | 0.0080 | | 0.00064 | 0.08 | Excellent | Excellent | Good | Excellent | Excellent | Good |
| Example17 | Bal. | 1.00 | 1.00 | 0.09 | 0.0080 | | 0.00072 | 0.09 | Excellent | Excellent | Excellent | Excellent | Excellent | Excellent |
| Example18 | Bal. | 1.00 | 1.00 | 0.11 | 0.0080 | | 0.00088 | 0.11 | Excellent | Excellent | Excellent | Excellent | Excellent | Excellent |
| Example19 | Bal. | 1.00 | 1.00 | 0.12 | 0.0080 | | 0.00096 | 0.12 | Excellent | Excellent | Excellent | Excellent | Good | Good |
| Example20 | Bal. | 1.00 | 1.00 | 0.20 | 0.0080 | | 0.00160 | 0.20 | Good | Good | Good | Good | Good | Good |
| Example21 | Bal. | 1.00 | 1.00 | 0.30 | 0.0080 | | 0.00240 | 0.30 | Good | Good | Good | Good | Good | Good |
| Example22 | Bal. | 1.00 | 1.00 | 0.40 | 0.0080 | | 0.00320 | 0.40 | Good | Good | Good | Good | Good | Good |
| Example23 | Bal. | 1.00 | 1.00 | 0.50 | 0.0080 | | 0.00400 | 0.50 | Good | Good | Good | Good | Good | Good |
| Example24 | Bal. | 1.00 | 1.00 | 0.60 | 0.0080 | | 0.00480 | 0.60 | Good | Good | Good | Good | Good | Good |

| | Alloy Composition (mass%) | | | | | | Relation (1) | Relation (2) | Wettability | Fracture Mode | Shear Strength (Mpa) | Drop Impact | IMC Crystal Grain Size | Deformed Bump |
|---|---|---|---|---|---|---|---|---|---|---|---|---|---|---|
| | Sn | Ag | Cu | Ni | Ge | Others | | | | | | | | |
| Example25 | Bal. | 1.00 | 1.00 | 0.10 | 0.0010 | | 0.00010 | 0.10 | Excellent | Excellent | Excellent | Excellent | Excellent | Good |
| Example26 | Bal. | 1.00 | 1.00 | 0.10 | 0.0060 | | 0.00060 | 0.10 | Excellent | Excellent | Excellent | Excellent | Excellent | Excellent |
| Example27 | Bal. | 1.00 | 1.00 | 0.10 | 0.0100 | | 0.00100 | 0.10 | Excellent | Excellent | Excellent | Excellent | Excellent | Excellent |
| Example28 | Bal. | 1.00 | 1.00 | 0.10 | 0.0150 | | 0.00150 | 0.10 | Good | Excellent | Excellent | Excellent | Excellent | Good |
| Example29 | Bal. | 1.00 | 1.00 | 0.10 | 0.0080 | Bi:0.01 | 0.00080 | 0.10 | Excellent | Excellent | Excellent | Excellent | Excellent | Excellent |
| Example30 | Bal. | 1.00 | 1.00 | 0.10 | 0.0080 | Sb:0.01 | 0.00080 | 0.10 | Excellent | Excellent | Excellent | Excellent | Excellent | Excellent |
| Example31 | Bal. | 1.00 | 1.00 | 0.10 | 0.0080 | In:0.01 | 0.00080 | 0.10 | Excellent | Excellent | Excellent | Excellent | Excellent | Excellent |

[Table 2]

| | Alloy Composition (mass%) | | | | | | Relation (1) | Relation (2) | Wettability | Fracture Mode | Shear Strength (Mpa) | Drop Impact | IMC Crystal Grain Size | Deformed Bump |
|---|---|---|---|---|---|---|---|---|---|---|---|---|---|---|
| | Sn | Ag | Cu | Ni | Ge | Others | | | | | | | | |
| Example32 | Bal. | 1.00 | 1.00 | 0.10 | 0.0080 | Zn:0.01 | 0.00080 | 0.10 | Excellent | Excellent | Excellent | Excellent | Excellent | Excellent |
| Example33 | Bal. | 1.00 | 1.00 | 0.10 | 0.0080 | Ga:0.01 | 0.00080 | 0.10 | Excellent | Excellent | Excellent | Excellent | Excellent | Excellent |
| Example34 | Bal. | 1.00 | 1.00 | 0.10 | 0.0080 | Mn:0.01 | 0.00080 | 0.10 | Excellent | Excellent | Excellent | Excellent | Excellent | Excellent |
| Example35 | Bal. | 1.00 | 1.00 | 0.10 | 0.0080 | Cr:0.01 | 0.00080 | 0.10 | Excellent | Excellent | Excellent | Excellent | Excellent | Excellent |
| Example36 | Bal. | 1.00 | 1.00 | 0.10 | 0.0080 | Co:0.01 | 0.00080 | 0.10 | Excellent | Excellent | Excellent | Excellent | Excellent | Excellent |
| Example37 | Bal. | 1.00 | 1.00 | 0.10 | 0.0080 | Si:0.01 | 0.00080 | 0.10 | Excellent | Excellent | Excellent | Excellent | Excellent | Excellent |
| Example38 | Bal. | 1.00 | 1.00 | 0.10 | 0.0080 | Ti:0.01 | 0.00080 | 0.10 | Excellent | Excellent | Excellent | Excellent | Excellent | Excellent |
| Example39 | Bal. | 1.00 | 1.00 | 0.10 | 0.0080 | RE:0.01 | 0.00080 | 0.10 | Excellent | Excellent | Excellent | Excellent | Excellent | Excellent |
| Example40 | Bal. | 1.00 | 1.00 | 0.10 | 0.0080 | Bi:0.001, Sb:0.001, In:0.001, Zn:0.001, Ga:0.001, Mn:0.001, Cr:0.001, Co:0.001, Si:0.001, Ti:0.001, RE:0.001 | 0.00080 | 0.10 | Excellent | Excellent | Excellent | Excellent | Excellent | Excellent |
| Comparative Example1 | Bal. | 0.05 | 1.00 | 0.10 | 0.0080 | | 0.00080 | 0.01 | Poor | Good | Poor | Good | Good | Good |
| Comparative Example2 | Bal. | 4.00 | 1.00 | 0.10 | 0.0080 | | 0.00080 | 0.40 | Good | Good | Poor | Poor | Good | Good |
| Comparative Example3 | Bal. | 2.50 | 0.50 | 0.08 | 0.0010 | | 0.00004 | 0.10 | Good | Good | Poor | Good | Good | Poor |
| Comparative Example4 | Bal. | 1.00 | 6.10 | 0.10 | 0.0080 | | 0.00488 | 0.61 | Poor | Poor | Poor | Poor | Poor | Poor |

(continued)

| | Alloy Composition (mass%) | | | | | | Relation (1) | Relation (2) | Wettability | Fracture Mode | Shear Strength (Mpa) | Drop Impact | IMC Crystal Grain Size | Deformed Bump |
|---|---|---|---|---|---|---|---|---|---|---|---|---|---|---|
| | Sn | Ag | Cu | Ni | Ge | Others | | | | | | | | |
| Comparative Example5 | Bal. | 1.00 | 1.00 | 0.00 | 0.0100 | | 0.00000 | 0.00 | Excellent | Poor | Poor | Good | Good | Good |
| Comparative Example6 | Bal. | 1.00 | 0.80 | 0.05 | 0.0010 | - | 0.00004 | 0.04 | Good | Good | Poor | Good | Good | Poor |
| Comparative Example7 | Bal. | 1.20 | 0.50 | 0.07 | 0.0100 | - | 0.00035 | 0.04 | Good | Good | Poor | Good | Good | Poor |
| Comparative Example8 | Bal. | 1.00 | 1.00 | 0.70 | 0.0100 | | 0.00700 | 0.70 | Poor | Poor | Poor | Poor | Poor | Poor |
| Comparative Example9 | Bal. | 1.00 | 1.00 | 0.10 | - | | - | 0.10 | Good | Excellent | Excellent | Excellent | Excellent | Poor |
| Comparative Example10 | Bal. | 1.00 | 1.00 | 0.10 | 0.0004 | | 0.00004 | 0.10 | Good | Excellent | Excellent | Excellent | Excellent | Poor |
| Comparative Example11 | Bal. | 1.00 | 1.00 | 0.10 | 0.0200 | - | 0.00200 | 0.10 | Poor | Excellent | Excellent | Excellent | Excellent | Poor |
| Comparative Example12 | Bal. | 1.00 | 1.00 | 0.10 | 0.0080 | P:0.01 | 0.00080 | 0.10 | Poor | Excellent | Excellent | Excellent | Excellent | Poor |
| Comparative Example13 | Bal. | 1.00 | 1.00 | 0.10 | 0.0080 | Fe:0.01 | 0.00080 | 0.10 | Poor | Excellent | Excellent | Excellent | Excellent | Poor |
| Comparative Example14 | Bal. | 1.00 | 3.00 | 0.50 | 0.0010 | Ce:0.1 | 0.00150 | 1.50 | Poor | Poor | Poor | Poor | Poor | Poor |
| * Underlined indicates that it is outside the scope of the present invention. | | | | | | | | | | | | | | |
| Comparative Example15 | Bal. | 1.00 | 3.00 | 0.50 | 0.0010 | Ce:0.1, P:0.001 | 0.00150 | 1.50 | Poor | Poor | Poor | Poor | Poor | Poor |
| Comparative Example16 | Bal. | 1.00 | 3.00 | 0.50 | 0.0010 | Ce:0.1, Ga:0.001 | 0.00150 | 1.50 | Poor | Poor | Poor | Poor | Poor | Poor |
| * Underlined indicates that it is outside the scope of the present invention. | | | | | | | | | | | | | | |

As is clear from Tables 1 and 2, since the contents of Ag, Cu, Ni, and Ge were all appropriate in Examples 1 to 40, all the evaluation items were "Good" or "Excellent". In addition, in Examples 2 to 4, 8, 9, 17, 18, 26, 27, and 29 to 40 satisfying Relations (1) and (2), it was found that the fracture mode, shear strength, drop impact, and deformed bump, which are evaluation items as a solder joint, were all "Excellent", and excellent effects were exhibited.

On the other hand, in Comparative Example 1, since the Ag content was small, the wettability and shear strength were poor. In Comparative Example 2, since the Ag content was large, the shear strength and the drop impact were poor. In Comparative Example 3, since the Cu content was small, the shear strength was poor, and a large number of deformed bumps were generated. In Comparative Example 4, since the Cu content was large, all evaluations were poor.

In Comparative Example 5, since Ni was not contained, the fracture mode was inappropriate, and the shear strength was poor. In Comparative Example 6 and Comparative Example 7, since the Ni content was small, the shear strength was poor, and a large number of deformed bumps were generated. In Comparative Example 8, since the Ni content was large, all evaluations were poor. In Comparative Example 9 and Comparative Example 10, since the Ge content was small, a large number of deformed bumps were generated. In Comparative Example 11, since the Ge content was large, the wettability was poor, and a large number of deformed bumps were generated. Since Comparative Example 12 and Comparative Example 13 each contained P and Fe, the wettability was poor, and a large number of deformed bumps were generated. In Comparative Examples 14 to 16, since Ce is contained, all evaluations were poor.

FIG. 1 is a surface SEM photograph of an intermetallic compound formed at a joint interface in a solder joint produced using a solder alloy of Example 3. FIG. 2 is a surface SEM photograph of an intermetallic compound formed at a joint interface in a solder joint produced using a solder alloy of Comparative Example 4. The particles shown in FIGS. 1 and 2 are IMC (intermetallic compound), and are images of SEM photographs taken with the "(5) IMC Grain Size" above. As is clear from FIGS. 1 and 2, the IMC of Example 3 was finer than the IMC of Comparative Example 4. In addition, in the IMC of Example 3, the shapes of the crystal grains were rounded and the surface irregularities of the IMC were small as compared with the IMC of Comparative Example 4. Therefore, in Example 3, the fracture mode was appropriate, the shear strength was high, and excellent drop impact resistance was exhibited. The same applies to other Examples, and in particular, in Examples 2, 4, 8, 9, 17, 18, 26, 27, and 29 to 40, excellent results were shown.

**Claims**

1. A solder alloy having an alloy composition consisting of, by mass%, Ag: 0.10 to 3.00%, Cu: 0.80 to 6.00%, Ni: 0.08 to 0.60%, Ge: 0.0010 to 0.0150%, with the balance being Sn.

2. The solder alloy according to claim 1, wherein the alloy composition further comprises at least one of Bi, Sb, In, Zn, Ga, Mn, Cr, Si, Ti, and rare earth elements: 0.1% or less in total.

3. The solder alloy according to claim 1 or 2, wherein the alloy composition satisfies the following Relations (1) and (2):

$$0.00043 \leqq Cu \times Ni \times Ge \leqq 0.00149 \qquad (1)$$

$$0.09 \leqq Ag \times Cu \times Ni \leqq 0.11 \qquad (2)$$

where Ag, Cu, Ni, and Ge in Relations (1) and (2) above represent the contents (mass%) thereof in the alloy composition.

4. A solder ball consisting of the solder alloy according to claim 1 or 2.

5. A solder preform consisting of the solder alloy according to claim 1 or 2.

6. A solder joint comprising the solder alloy according to claim 1 or 2.

7. A circuit comprising the solder joint according to claim 6.

FIG. 1

Intermetallic compound

FIG. 2

Intermetallic compound

## INTERNATIONAL SEARCH REPORT

| | International application No. |
|---|---|
| | **PCT/JP2024/015538** |

### A. CLASSIFICATION OF SUBJECT MATTER

**B23K 35/26**(2006.01)i; **C22C 13/00**(2006.01)i; **H05K 3/34**(2006.01)i
FI: B23K35/26 310A; C22C13/00; H05K3/34 512C

According to International Patent Classification (IPC) or to both national classification and IPC

### B. FIELDS SEARCHED

Minimum documentation searched (classification system followed by classification symbols)

B23K35/26; C22C13/00; H05K3/34

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2021-126685 A (SENJU METAL INDUSTRY CO., LTD.) 02 September 2021 (2021-09-02)<br>entire text | 1-7 |
| A | JP 2021-28078 A (SENJU METAL INDUSTRY CO., LTD.) 25 February 2021 (2021-02-25)<br>entire text | 1-7 |
| A | JP 11-77366 A (FUJI ELECTRIC CO., LTD.) 23 March 1999 (1999-03-23)<br>entire text | 1-7 |
| A | JP 2007-237252 A (NIPPON STEEL MATERIALS CO., LTD.) 20 September 2007 (2007-09-20)<br>entire text | 1-7 |
| A | WO 2012/133598 A1 (SENJU METAL INDUSTRY CO., LTD.) 04 October 2012 (2012-10-04)<br>entire text | 1-7 |

☑ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **27 June 2024** | **09 July 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

International application No.

**PCT/JP2024/015538**

### C. DOCUMENTS CONSIDERED TO BE RELEVANT

| Category* | Citation of document, with indication, where appropriate, of the relevant passages | Relevant to claim No. |
|---|---|---|
| A | WO 2014/002283 A1 (SENJU METAL INDUSTRY CO., LTD.) 03 January 2014 (2014-01-03)<br>entire text | 1-7 |
| A | WO 2014/170963 A1 (SENJU METAL INDUSTRY CO., LTD.) 23 October 2014 (2014-10-23)<br>entire text | 1-7 |

Form PCT/ISA/210 (second sheet) (July 2022)

**INTERNATIONAL SEARCH REPORT**
Information on patent family members

| Patent document cited in search report | | | Publication date (day/month/year) | Patent family member(s) | | | Publication date (day/month/year) |
|---|---|---|---|---|---|---|---|
| JP | 2021-126685 | A | 02 September 2021 | US | 2023/0060857 | A1 | |
| | | | | entire text | | | |
| | | | | WO | 2021/161953 | A1 | |
| | | | | EP | 4105349 | A1 | |
| | | | | TW | 202138576 | A | |
| | | | | KR | 10-2022-0129112 | A | |
| | | | | CN | 115397605 | A | |
| | | | | BR | 112022016141 | A2 | |
| | | | | MX | 2022009912 | A | |
| | | | | JP | 2021-126704 | A | |
| JP | 2021-28078 | A | 25 February 2021 | US | 2022/0324061 | A1 | |
| | | | | entire text | | | |
| | | | | WO | 2021/029222 | A1 | |
| | | | | EP | 3988239 | A1 | |
| | | | | TW | 202106891 | A | |
| | | | | KR | 10-2022-0025110 | A | |
| | | | | BR | 112022001982 | A2 | |
| | | | | MX | 2022001714 | A | |
| | | | | CN | 114245765 | A | |
| JP | 11-77366 | A | 23 March 1999 | US | 6179935 | B1 | |
| | | | | entire text | | | |
| | | | | DE | 19816671 | A1 | |
| JP | 2007-237252 | A | 20 September 2007 | US | 2009/0304545 | A1 | |
| | | | | entire text | | | |
| | | | | WO | 2007/102588 | A1 | |
| | | | | KR | 10-2008-0101643 | A | |
| | | | | TW | 200740549 | A | |
| WO | 2012/133598 | A1 | 04 October 2012 | US | 2014/0061287 | A1 | |
| | | | | entire text | | | |
| | | | | EP | 2692478 | A1 | |
| | | | | SG | 193412 | A1 | |
| | | | | CN | 103547408 | A | |
| | | | | TW | 201343311 | A | |
| | | | | KR | 10-2014-0025406 | A | |
| WO | 2014/002283 | A1 | 03 January 2014 | US | 2015/0221606 | A1 | |
| | | | | entire text | | | |
| | | | | EP | 2886243 | A1 | |
| | | | | KR | 10-2014-0015242 | A | |
| | | | | CN | 104602862 | A | |
| | | | | MX | 2015000222 | A | |
| | | | | HK | 1204779 | A1 | |
| | | | | TW | 201412449 | A | |
| | | | | CN | 106964917 | A | |
| | | | | BR | 112014032941 | A2 | |
| WO | 2014/170963 | A1 | 23 October 2014 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020135932 A
- WO 2007102588 A
- JP 2008093701 A
- JP 2013049073 A